Europäisches Patentamt

European Patent Office

Office européen des brevets

(11) Numéro de publication: **0 376 387**
**A1**

## (12) DEMANDE DE BREVET EUROPEEN

(21) Numéro de dépôt: 89203264.0

(22) Date de dépôt: **20.12.89**

(51) Int. Cl.5. **H01L 21/00**

(30) Priorité: **30.12.88 FR 8817496**

(43) Date de publication de la demande:
**04.07.90 Bulletin 90/27**

(84) Etats contractants désignés:
**DE FR GB IT NL**

(71) Demandeur: **LABORATOIRES D'ELECTRONIQUE PHILIPS**
**3, Avenue Descartes**
**F-94450 Limeil-Brévannes(FR)**

(84) **FR**

Demandeur: **N.V. Philips' Gloeilampenfabrieken**
**Groenewoudseweg 1**
**NL-5621 BA Eindhoven(NL)**

(84) **DE GB IT NL**

(72) Inventeur: **Houdy, Philippe**

Société CIVILE S.P.I.D. 209 rue de l'Université
**F-75007 Paris(FR)**
Inventeur: **Greco, Roger**
Société CIVILE S.P.I.D. 209 rue de l'Université
**F-75007 Paris(FR)**
Inventeur: **Morhaim, Claude**
Société CIVILE S.P.I.D. 209 rue de l'Université
**F-75007 Paris(FR)**
Inventeur: **Delarue, François**
Société CIVILE S.P.I.D. 209 rue de l'Université
**F-75007 Paris(FR)**

(74) Mandataire: **Landousy, Christian et al**
**Société Civile S.P.I.D. 209, Rue de l'Université**
**F-75007 Paris(FR)**

(54) **Dispositif incluant un porte-échantillons chauffant.**

(57) Dispositif incluant un porte-échantillons chauffant, lequel comprend une surface portante, un système de chauffage électrique, et une monture, caractérisé en ce que ces éléments sont non solidaires les uns des autres et du dispositif, et qu'ils sont respectivement emboîtables.

A cet effet, le système de chauffage électrique (40) comprend un disque en un matériau isolant réfractaire (40) dont la surface supérieure est munie d'un ensemble de résistances électriques (45), formées de couches sérigraphiées résistives (45a à 45j) pour le corps des résistances et conductrices (41;42) pour leurs extrémités, lesquelles coïncident avec des trous métallisés (41 et 42 a à e) qui les relient à des lignes conductrices sérigraphiées sur la face inférieure du disque pour connecter les résistances (45) en parallèle.

D'autre part, la face inférieure de la monture (9,10) porte des pistes conductrices concentriques (1,2,3), isolées l'une de l'autre et de la monture, le connexion entre les pistes et le circuit de résistances est réalisée au moyen d'une broche métallique (1', 2', 3') par piste, traversant la monture dans le centre de pertes isolantes et coïncidant avec les trous métallisés (41 et 42 a à e). Pour alimenter les pistes (1,2,3) des plots (101, 102, 103) sont prévus sur le support de monture qui est un plateau tournant (100) et qui est muni d'une lumière (110) pour l'introduction de l'axe (9) de la monture.

Application : Réalisation de circuits intégrés nécessitant des 1 recuits, notamment dans des atmosphères agressives

FIG.1

## DISPOSITIF INCLUANT UN PORTE-ECHANTILLONS CHAUFFANT

L'invention concerne un dispositif incluant un porte-échantillons chauffant, lequel comprend une surface portante, un système de chauffage électrique et une monture.

L'invention trouve son application dans l'industrie des semiconducteurs, dans la mesure ou pour réaliser des circuits comprenant des couches sur des plaquettes, il est nécessaire de soumettre ces couches à des recuits lors de l'élaboration du circuit, c'est-à-dire in situ.

L'invention trouve une application particulière dans la réalisation de circuits en couche mince de matériau supraconducteur, réalisation qui nécessite des recuits.

D'une façon générale, l'invention trouve son application dans toute mise en oeuvre nécessitant le chauffage d'un substrat dans une enceinte fermée et notamment sous-vide ou sous atmosphère agressive.

Un dispositif du commerce destiné au chauffage d'échantillons dans une chambre à vide est commercialisé par la société française "MECA 2000". Ce dispositif connu consiste en un porte-échantillons standard muni d'un système de chauffage. Le porte-échantillons est massif. Il présente la forme générale d'un grand clou à tête plate en forme de disque, la surface supérieure de ce disque constituant la surface portante de l'échantillon. Le système de chauffage consiste en un filament métallique disposé en forme de serpentin sur la face arrière du disque, et qui élève la température de l'échantillon placé sur l'autre face, par l'intermédiaire du métal composant le disque. A cet effet, ce métal doit présenter une bonne conductibilité thermique. Il est aussi important de noter que le porte-échantillons est fixé au bâti de l'enceinte à vide, et n'est pas amovible d'une façon simple. Le filament chauffant est alimenté électriquement par l'intermédiaire d'une canne de transfert. Ainsi, le porte-échantillons est lié au bâti par les fils d'alimentation électrique du filament chauffant. Ce moyen de connexion électrique interdit de désolidariser le porte-échantillons du bâti, excepté lors d'une opération de démontage complet et non pas par un simple déplacement. Cependant, il existe une petite latitude de déplacement du porte-échantillons parallèlement à la canne, mais il n'en résulte qu'une légère inclinaison de l'échantillon par rapport à l'horizontale.

L'inconvénient majeur de ce porte-échantillons est donc qu'il est assujetti à demeure à une enceinte à vide donnée. Il est donc malaisé de le déplacer dans l'enceinte qui le contient ou bien d'une enceinte à l'autre.

Pour l'application envisagée au recuit de couche lors de l'élaboration de circuits intégrés, ou à la réalisation de couches à chaud, le dispositif connu présente en outre un certain nombre d'inconvénients.

En premier lieu, il n'est pas apte à chauffer d'une manière homogène des échantillons de grande surface, ou plusieurs échantillons juxtaposés sur la surface portante, créant une grande surface à chauffer. Ceci est dû au mode d'application et à la forme du filament chauffant, qui créent dans le ou les échantillons placés en surface du support des gradients de température importants. En particulier en fonctionnement, la température de la surface portante est beaucoup plus grande en son centre que sur sa périphérie.

En second lieu, "l'image" du filament apparaît sur la couche qui a subit le chauffage.

En troisième lieu, ce dispositif est très fragile. En effet, il apparaît, lors de la mise en forme du serpentin constituant le filament, des contraintes dans le métal, lesquelles rendent ce filament cassant au chauffage. Ce dispositif devient donc hors d'usage après un temps d'utilisation très court. Comme il se trouve qu'il est en outre très onéreux, son utilisation est donc d'un coût particulièrement élevé.

En quatrième lieu, ce porte-échantillons a tendance à dégazer. Ce dégazage provient du matériau utilisé pour réaliser le filament. De ce fait, l'utilisateur de ce dispositif ne peut pas obtenir, dans l'enceinte à vide, des valeurs meilleures que $10^{-6}$ torrs. Ces valeurs sont considérées comme rédhibitoires pour l'élaboration de couches dans les technologies de circuits intégrés où des valeurs de $10^{-\ddot{E}}$ torrs doivent le plus souvent être atteintes impérativement.

En cinquième lieu, ce dispositif peut aussi présenter une fragilité liée à certains types d'utilisation. Il n'est pas rare en effet, que dans les technologies de circuit intégré, on soit amené à réaliser dans l'enceinte à vide des dépôts métalliques ou isolants par une méthode dite de pulvérisation, en utilisant des gaz tels que :

Ar, O, N, H, en combinaison avec des gaz tels que : $Cl_2$ ou F, sous pression partielle faible, pour former un plasma. L'utilisation du dispositif connu est exclue de ce genre d'application car les plasmas formés sont corrosifs pour le filament chauffant et le détruisent.

Selon l'invention, ces inconvénients sont évités au moyen d'un dispositif muni des éléments décrits dans le préambule et en outre caractérisé en ce que ces éléments sont non solidaires les uns des autres et du dispositif, et qu'ils sont respectivement emboîtables.

Le porte-échantillon du dispositif selon l'invention fournit ainsi l'avantage essentiel de pouvoir être aisément déplacé dans l'enceinte qui le contient, ou bien d'une enceinte à une autre.

Dans une réalisation, ce dispositif est caractérisé en ce que le système de chauffage électrique comprend un disque en un matériau isolant réfractaire dont la surface supérieure est munie d'un ensemble de résistances électriques.

Le dispositif selon l'invention présente alors l'avantage d'être très facile à réaliser, et d'être très bon marché.

Eventuellement, le disque muni des résistances peut être échangé facilement.

Dans une mise en oeuvre particulière, ce dispositif est caractérisé en ce que l'ensemble des résistances électriques est formé par des couches respectivement résistives pour le corps des résistances et conductrices pour les extrémités. Ces couches peuvent avantageusement être du type dit sérigraphié.

La technologie utilisée pour réaliser le circuit de résistance chauffante est particulièrement souple à mettre en oeuvre et on peut trouver une forme de dessin qui couvre bien toute la surface chauffante, et ceci d'une façon uniforme. Les gradients de température sont alors supprimés.

Dans une réalisation, le dispositif selon l'invention est caractérisé en ce que le matériau pour constituer le disque réfractaire est une vitrocéramique.

Dans cette réalisation, le dispositif selon l'invention est particulièrement résistant à l'agression des agents chimiques et on sait en outre réaliser des couches sérigraphiées pour former l'ensemble de résistances chauffantes capable de fournir des températures très importantes. Qui plus est, dans cette réalisation, le disque ne dégaze pas, et, si le porte-échantillons doit être utilisé dans une chambre à vide, alors des vides très poussés peuvent être atteints.

Dans une réalisation, le dispositif est caractérisé en ce qu'un disque isolant électriquement et réfractaire est disposé dans le fond de l'évidement de la monture entre le disque réfractaire et la monture.

Dans cette réalisation on peut atteindre de très hautes températures. En effet, cette mise en oeuvre permet d'isoler thermiquement le disque réfractaire de la monture à ces températures.

Dans une réalisation, le dispositif est caractérisé en ce que la surface portante du porte-échantillons est formée par la face supérieure d'une couronne en un matériau isolant et réfractaire portée par la face supérieure de la monture, la hauteur de cette couronne étant telle que cette surface portante est à une petite distance de la surface des résistances du disque réfractaire.

Dans cette réalisation la petite distance qui est ainsi créée entre la surface chauffante et l'échantillon permet de minimiser encore les gradients de température dans l'échantillon.

Dans une réalisation, le dispositif est caractérisé en ce que la face inférieure de la monture porte au moins deux pistes conductrices isolées l'une de l'autre et de la monture pour former le système d'alimentation électrique de l'ensemble des résistances. Dans cette réalisation la connexion électrique entre les pistes et le circuit des résistances est réalisée au moyen d'au moins une broche métallique par piste traversant l'épaisseur de la monture dans le centre d'une perle isolante, ces broches étant disposées selon un dessin approprié à coïncider avec les trous métallisés du disque réfractaire, et étant d'un diamètre approprié à entrer dans ces trous métallisés en fournissant le contact électrique cherché.

Dans cette réalisation, le raccord électrique entre le disque portant les résistances et l'alimentation électrique est particulièrement simple et efficace puisqu'il s'agit d'un simple emboitement des broches portées par la monture dans les trous métallisés du disque réfractaire.

Dans une réalisation, ce dispositif est caractérisé en ce que la monture porte trois pistes conductrices, deux de ces pistes étant consacrées à l'alimentation de l'ensemble des résistances et la troisième piste, externe aux deux autres étant consacrée à une tension de polarisation.

Par cette réalisation, on obtient une amélioration des résultats sur les échantillons traités par plasma, du fait que l'on peut procéder à leur polarisation.

Dans une réalisation ce dispositif est caractérisé en ce qu'un disque métallique réfractaire est disposé en surface de la face supérieure de la couronne, ce disque formant alors la surface portante pour l'échantillon. Ce disque peut être favorablement réalisé en mobybdène.

Le disque métallique permet alors de minimiser encore les gradients de température dans l'échantillon. Si le disque métallique est en molybdène, il supporte les fortes températures sans s'oxyder et sans dégazer.

Dans une forme de réalisation, le dispositif est caractérisé en ce que les pistes conductrices sont des couronnes concentriques. Ces pistes peuvent être rigides et isolées électriquement les unes des autres et de la monture au moyen de couronnes de matériau isolant réfractaire, d'autre part le support de monture comprend des plots d'alimentation électrique, en nombre au moins égal au nombre de pistes de la monture, disposés selon un dessin approprié à venir en contact chacun avec une des pistes de cette monture.

Dans cette forme de réalisation l'élément chauffant placé dans la monture est alimenté électriquement en posant simplement cette monture sur le support de monture.

Dans une réalisation le support de monture est un plateau tournant autour d'un axe solidaire du dispositif.

Le fait que le support de monture soit tournant dans le dispositif permet de disposer plusieurs porte-échantillons dans ce dispositif, de manière telle que tous les échantillons sont traités d'une manière homogène du fait de la rotation.

Dans une réalisation, l'alimentation des plots du plateau tournant se fait par le frottement de pistes électriques tournantes solidaires du plateau tournant et de pistes électriques fixes solidaires du dispositif, ces pistes étant isolées les unes des autres électriquement ainsi que de leur support respectif et les pistes du plateau tournant étant reliées électriquement respectivement aux plots du plateau tournant, ces pistes étant en outre en nombre au moins égal à celui des pistes de la monture.

De cette manière, l'alimentation électrique du plateau tournant est facile à réaliser. De plus, si les résistances chauffantes sont du type sérigraphié, l'alimentation électrique se fait sous une faible tension, par exemple 30V, et non pas 220V comme le dispositif connu.

L'invention sera mieux comprise au moyen de la description suivante illustrée par les figures ci-après annexées dont :

- la figure 1 qui représente un ensemble comprenant un support de monture et un porte-échantillons selon l'invention ;

- les figures 2a à 2c qui représentent la monture et les différents éléments du porte-échantillons qui s'emboitent dans la monture selon l'invention ;

- la figure 3 qui représente le support de monture ;

- les figures 4a et 4b qui représentent le circuit de résistances et le circuit d'alimentation des résistances selon l'invention.

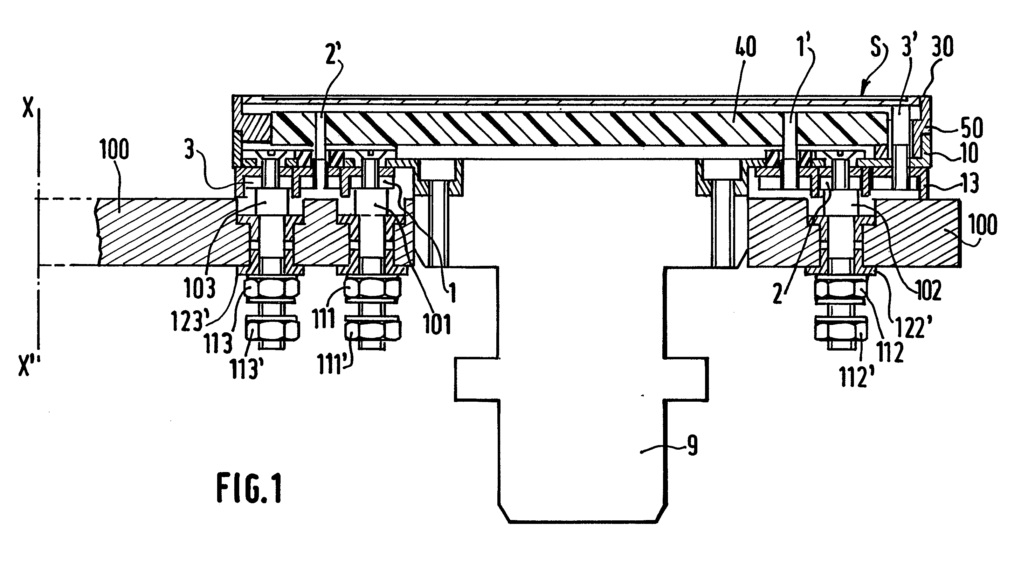

Tel que représenté sur la figure 1, le porte-échantillons selon l'invention comprend un support de monture 100, une monture 10 munie d'un axe de centrage 9, une couronne isolante 50, un élément chauffant 40, un support pour l'échantillon 30 et l'échantillon lui-même S. Ce porte-échantillons comprend en outre des plots d'alimentation 101, 102, 103 solidaires du support de monture 100 et des pistes d'alimentation 1, 2 et 3 solidaires de la monture 10. De plus, pour connecter l'élément chauffant 40, des broches d'alimentation 1´, 2´ 3´ solidaires respectivement des pistes conductrices 1, 2 et 3 entrent dans des trous métallisés de l'élément chauffant 40.

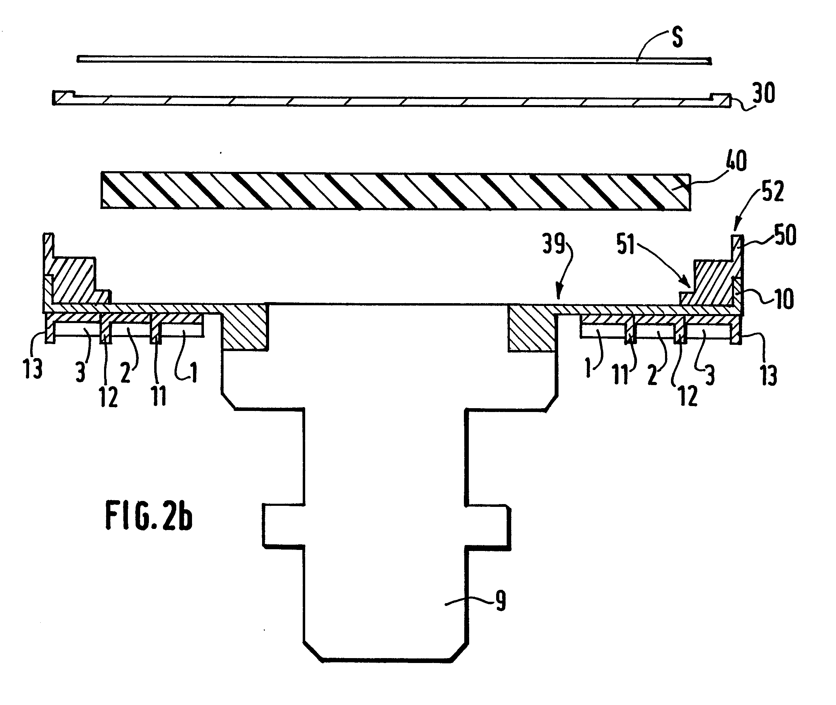

Telle que représentée sur la figure 2b, la monture 10 du porte-échantillons selon l'invention est un disque présentant un logement 39 circulaire dans sa partie supérieure. Ce logement est destiné à recevoir tout d'abord une couronne 50 en un matériau isolant réfractaire par exemple l'alumine ou tout autre céramique. Cette couronne 50 circulaire est favorablement munie d'un épaulement 51 pour recevoir l'élément chauffant 40.

L'élément chauffant 40 est favorablement un disque en un matériau isolant réfractaire. Selon l'invention on choisira de préférence comme matériau isolant réfractaire une vitrocéramique présentant l'avantage d'un très faible coefficient de dilatation linéaire en fonction de la température.

Au lieu de l'épaulement 51 prévu dans la couronne 50 on pourra aussi disposer sous le disque chauffant 40 un disque en un matériau isolant réfractaire pour isoler thermiquement le disque 40 de la monture 10 métallique.

La surface supérieure 52 de la couronne isolante 50 représente la surface portante pour l'échantillon S. Elle est prévue pour que cet échantillon soit disposé à une petite distance au-dessus du disque chauffant 40. Cependant, dans le but de minimiser les gradients de température sur le substrat S, on peut favorablement interposer une plaque métallique 30 qui vient s'appuyer sur la surface 52 de la couronne 50 et qui constitue alors la surface portante pour l'échantillon.

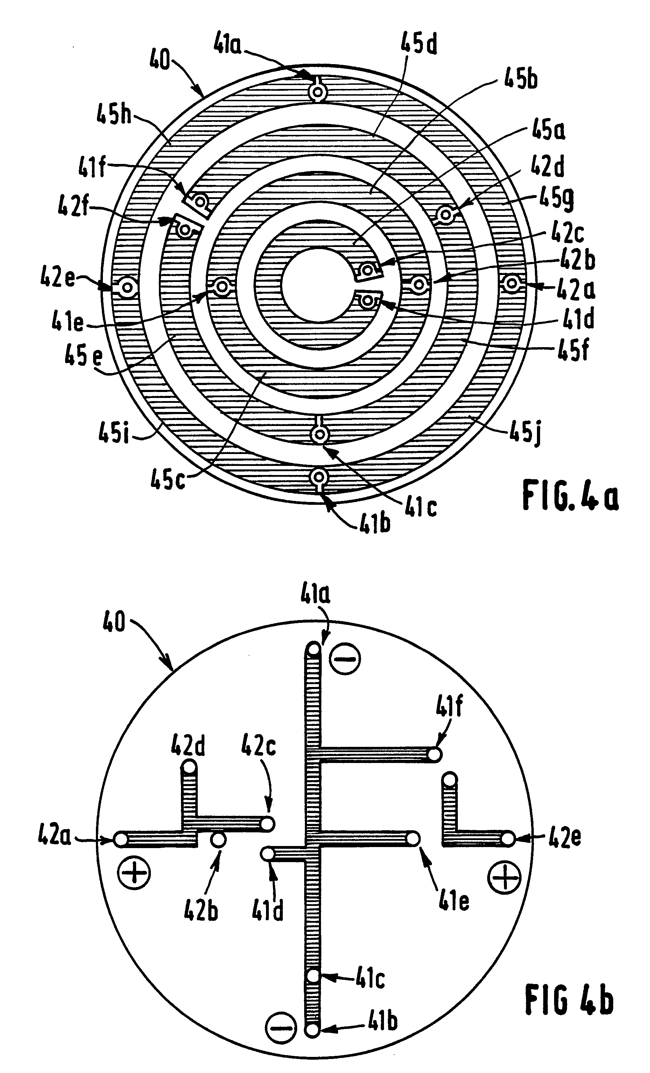

Tel que représenté sur la figure 4a, le disque chauffant 40 comprend à sa surface supérieure un ensemble de résistances chauffantes 45a à 45j toutes montées en parallèle. Ces résistances chauffantes sont selon l'invention réalisées au moyen de couches sérigraphiées telles que décrites dans la demande de brevet européen N° 88202637.0. Pour réaliser cet ensemble de résistances, on a donc d'abord déposé à la surface du disque 40 une première couche isolante puis une couche résistive pour constituer le corps des résistances et une couche conductrice pour constituer les extrémités des résistances. Coïncidant avec les extrémités des résistances, des trous sont percés dans le disque chauffant 40. Ces trous sont métallisés au moyen du même matériau que celui qui sert à réaliser les extrémités des résistances tel que présenté sur la figure 4b. La face inférieure du disque chauffant 40 porte un circuit de lignes conductrices. Ce circuit est prévu pour relier entre elles les extrémités des résistances destinées à être connectées à une borne positive d'une alimentation et pour relier entre elles les extrémités des résistances destinées à être connectées à une borne négative d'une alimentation électrique. Le dessin de l'ensemble des résistances représenté sur la figure 4a et le dessin du circuit de connexion représenté sur la figure 4b sont donnés tout à fait à titre d'exemples pour obtenir un élément chauffant sur lequel les résistances électriques sont réparties de façon homogène permettant de minimiser ainsi les gradients de température à la surface.

Notamment au moyen d'un élément chauffant tel que décrit ci-dessus et dont les résistances et le circuit d'alimentation sont représentés sur la figure 4 on a pu obtenir pour l'échantillon des températures de l'ordre de 550° ± 10°. Le procédé de sérigraphie utilisé pour réaliser les résistances chauffantes est un procédé particulièrement facile à mettre en oeuvre, peu coûteux et qui permet d'obtenir des dessins disposés selon des configurations propres à couvrir toute la surface du disque chauffant 40. De plus, ce circuit ne nécessite qu'une faible tension d'alimentation électrique.

Les trous métallisés 41 et 42 ont deux fonctions. D'une part il assurent la connexion entre les extrémités des résistances disposées à la surface supérieure du disque 40 et le circuit de connexion disposé sur la face inférieure du disque 40, et d'autre part il permettent de connecter l'ensemble des résistances aux bornes d'une alimentation car il permettent l'introduction de broches portées par la monture.

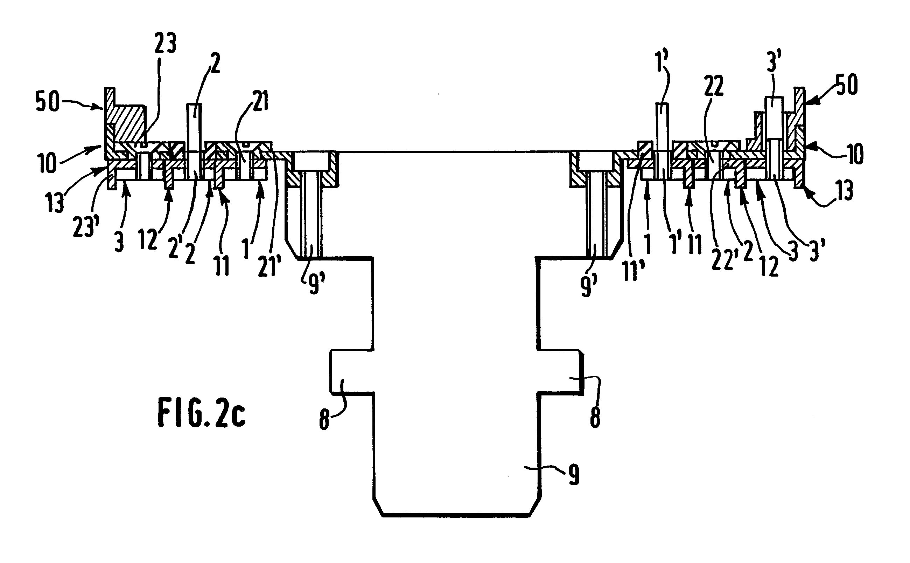

Telle que représentée sur la figure 2c, la monture 10 comprend sur sa face inférieure un ensemble de pistes 1, 2 et 3 conductrices qui sont ici des pistes circulaires rigides en un matériau bon conducteur de l'électricité. Ces pistes 1, 2 et 3 peuvent être fixées à la monture 10 au moyen de vis 21, 22, 23, ce montage étant isolé de la monture 10 au moyen de perles isolantes 21', 22', 23'. A ces pistes conductrices 1, 2, 3 sont aussi fixées des broches métalliques 1', 2' et 3', ces broches traversant la monture 10 à travers des perles isolantes 11', 12', 13'. Le dessin selon lequel les broches 1', 2' et 3' traversent la monture est aussi prévu pour que ces broches soient en coïncidence avec des trous métallisés 41 pour broches 1', 42 pour les broches 2'. Les broches 3' sont prévues plus longues de manière à traverser la couronne isolante 50 et à permettre le contact sur le support d'échantillons 30. Par ce contact on peut amener sur le support d'échantillons 30 une tension de polarisation de l'échantillon qui peut être particulièrement utile dans le cas où le porte-échantillon selon l'invention est destiné à être utilisé dans un réacteur de plasma.

Avec le dessin proposé sur la figure 4, pour l'ensemble des résistances et son circuit d'alimentation il n'est pas nécessaire de prévoir plus de quatre broches. La première étant reliée à la piste 1 pour connecter le circuit à une première borne d'alimentation, deux broches étant reliées à la piste 2 pour connecter le circuit à une seconde borne d'alimentation et la quatrième broche étant reliée à la piste 3 pour polariser éventuellement l'échantillon.

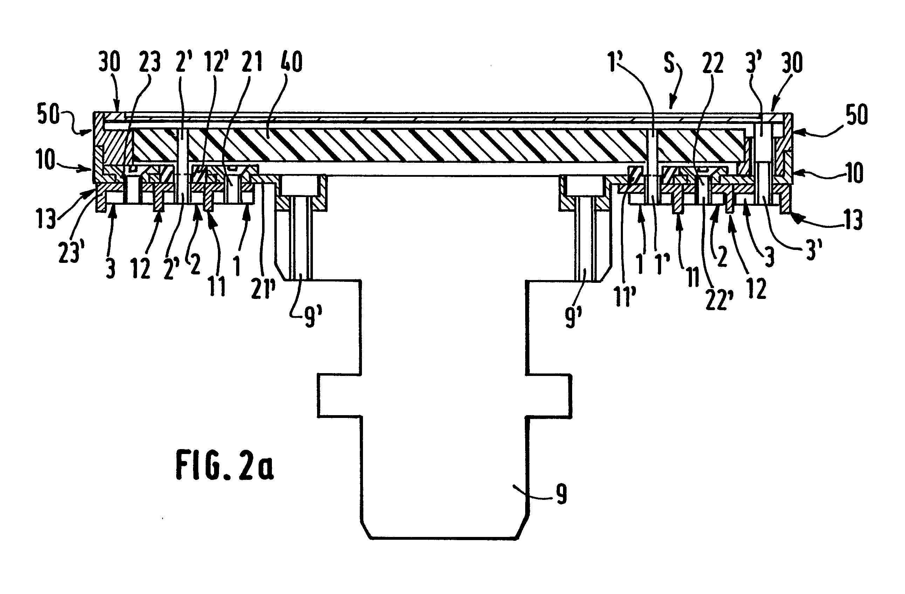

La figure 2a représente la monture du porte-échantillons ainsi équipée. La monture peut être réalisée en n'importe quel métal et plus favorablement en un métal qui ne dégaze pas et qui ne s'oxyde pas tel que l'acier inoxydable. La monture 10 comprend aussi un axe de centrage 9 qui peut être fixé à la monture 10 par exemple par des vis 9'. Cet axe 9 peut être réalisé dans un autre métal que celui de la monture 10 par exemple un métal lourd tel que le tungtène afin d'assurer à la monture un certain poids qui permettra ensuite le contact électrique parfait des pistes 1, 2 et 3 sur les plots d'alimentation 101, 102, 103 du support de monture 100. L'axe 9 peut comprendre aussi favorablement un épaulement 8 pour permettre la préhension de la monture au moyen d'une fourche de façon à pouvoir effectuer son déplacement d'une manière aisée lorsque la monture est introduite dans un bâti ou lorsque l'on veut l'en extraire.

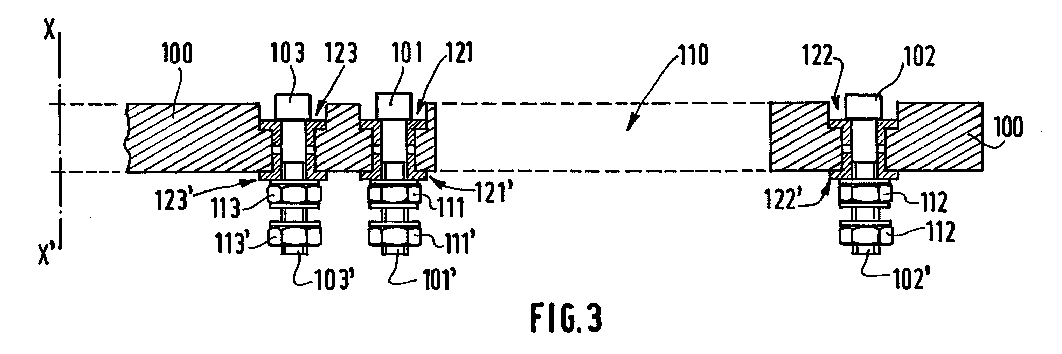

Tel que représenté sur la figure 3, le support de monture 100 peut être favorablement un plateau tournant autour d'un axe XX'. Ce plateau comprend une ouverture 110 par laquelle on introduit l'axe 9 de la monture 10. Ce plateau comprend également des plots métalliques 101, 102, 103 constitués par exemple par les têtes de vis métalliques qui traversent la plaque 100 et sont isolées de cette plaque par des perles isolantes 121, 121', 122, 122', 123, 123' respectivement pour les plots 101, 102, 103. Ces plots peuvent ainsi être assujettis au plateau 100 au moyen d'écrous respectivement 111, 112, 113. Pour amener le courant sur les plots 101, 102, 103 on peut fixer par les écrous 111', 112', 113' des conducteurs électriques.

Afin que l'ouverture 110 permette un centrage précis de la monture 10 sur le plateau 100, l'axe 9 de la monture peut d'abord être introduit dans une lumière du plateau faisant suite à l'ouverture 110, puis glissée dans cette lumière jusqu 'au centre de l'ouverture 110.

Le porte-échantillons chauffant selon l'invention est destiné à être introduit dans un dispositif tel qu'une chambre à vide, un réacteur à plasma etc... Dans le but d'alimenter les plots 101, 102, 103 du plateau tournant au moyen des conducteurs reliés aux écroux 111', 112', 113', on peut prévoir dans le dispositif ou bâti des pistes métalliques circulaires contre lesquelles des pistes métalliques également circulaires solidaires du plateau viendront frotter lorsque le plateau tournera. Les pistes métalliques solidaires du bâti sont prévues en nombre suffisant pour alimenter des pistes solidaires du plateau tournant également en nombre suffisant pour être connectées aux plots du plateau 100. Les pistes tournantes solidaires du plateau 100 et les écrous 111', 112', 113' peuvent être connectées au moyen de fils souples.

Les matériaux isolants pour réaliser notamment les perles isolantes du dispositif selon l'invention peuvent être en toute céramique, le plateau tournant peut être en acier inoxydable. Le support d'échantillons 30 sera favorablement en molybdène qui supporte les hautes températures sans dégazer.

**Revendications**

1. Dispositif incluant un porte-échantillons chauffant, lequel comprend une surface portante, un système de chauffage électrique, et une monture, caractérisé en ce que ces éléments sont non solidaires les uns des autres et du dispositif, et qu'ils sont respectivement emboîtables.

2. Dispositif selon la revendication 1, caractérisé en ce que le système de chauffage électrique comprend un disque en un matériau isolant réfractaire dont la surface supérieure est munie d'un ensemble de résistances électriques.

3. Dispositif selon la revendication 2, caractérisé en ce que l'ensemble de résistances électriques est formé par des couches respectivement résistives pour le corps des résistances et conductrices pour leurs extrémités.

4. Dispositif selon la revendication 3, caractérisé en ce que les couches pour former l'ensemble de résistances élctriques sont du type dit sérigraphié.

5. Dispositif selon l'une des revendications 3 ou 4, caractérisé en ce que le disque réfractaire est en outre muni de trous métallisés disposés en coïncidence avec les extrémités des résistances.

6. Dispositif selon la revendication 5, caractérisé en ce que la face inférieure du disque réfractaire est en outre munie d'un circuit de lignes conductrices disposées selon un dessin approprié à connecter l'ensemble des résistances en parallèle, et en ce que ce circuit est connecté à l'ensemble des résistances par le moyen des métallisations des trous.

7. Circuit selon la revendication 6, caractérisé en ce que le circuit de ligne conductrice et les métallisations des trous sont formés par des couches du type dit sérigraphié.

8. Dispositif selon l'une des revendications 2 à 7, caractérisé en ce que le matériau pour constituer le disque réfractaire est une vitrocéramique.

9. Dispositif selon la revendication 8, caractérisé en ce que l'ensemble des résistances est réalisé sur la face supérieure du disque réfractaire au moyen d'une première couche isolante, d'une seconde couche conductrice et d'une troisième couche résistive.

10. Dispositif selon l'une des revendications 1 à 9, caractérisé en ce qu'il comprend un support de monture pour recevoir la monture du porte-échantillons.

11. Dispositif selon la revendication 10, dans la mesure où elle dépend de la revendication 2, caractérisé en ce que la monture est un disque métallique dont la face supérieure comprend un évidement pour recevoir le disque réfractaire.

12. Dispositif selon la revendication 11, dans la mesure où elle dépend de l'une des revendications 8 ou 9, caractérisé en ce qu un disque isolant électriquement et réfractaire est disposé dans le fond de l'évidement de la monture, entre le disque réfractaire et la monture.

13. Dispositif selon l'une des revendications 11 ou 12, caractérisé en ce que la surface portante du porte-échantillons est formée par la face supérieure d'une couronne en un matériau isolant et réfractaire, portée par la face supérieure de la monture, la hauteur de cette couronne étant telle que cette surface portante est à une petite distance de la surface des résistances du disque réfractaire.

14. Dispositif selon la revendication 13, dans la mesure où elle dépend de la revendication 12, caractérisé en ce que la couronne est disposée dans l'évidement de la monture de manière à entourer ledit disque réfractaire et éventuellement le disque isolant.

15. Dispositif selon la revendication 14, caractérisé en ce que la couronne a la forme d'un L, la partie supérieure du L étant d'un diamètre très légèrement supérieur à celui du disque réfractaire et éventuellement munie d'un épaulement pour le soutenir et la partie inférieure du L d'un diamètre très légèrement supérieur à celui du disque isolant quand il existe, l'épaisseur du L étant en outre prévue pour que la couronne soit d'un diamètre externe légèrement inférieur à celui de l'évidement de la face supérieure de la monture.

16. Dispositif selon l'une des revendications 10 à 15, dans la mesure où elle dépend de la revendication 5, caractérisé en ce que la face inférieure de la monture porte au moins deux pistes conductrices isolées l'une de l'autre et de la monture, pour former le système d'alimentation électrique de l'ensemble des résistances.

17. Dispositif selon la revendication 16, caractérisé en ce que la connexion électrique entre les pistes et le circuit des résistances est réalisée au moyen d'au moins une broche métallique par piste traversant l'épaisseur de la monture dans le centre de perles isolantes, ces broches étant disposées selon un dessin approprié à coïncider avec les trous métallisés du disque réfractaire et étant d'un diamètre approprié à entrer dans ces trous métallisés en fournissant le contact électrique cherché.

18. Dispositif selon l'une des revendications 16 ou 17, caractérisé en ce que la monture porte trois pistes conductrices, deux de ces pistes étant consacrées à l'alimentation de l'ensemble des résistances, et la troisième piste, disposée de façon externe aux deux autres, étant consacrée à une tension de polarisation.

19. Dispositif selon l'une des revendications 13 à 18, caractérisé en ce qu'un disque métallique réfractaire est disposé en surface de la face supérieure de la couronne réfractaire, ce disque formant alors la surface portante pour l'échantillon.

20. Dispositif selon la revendication 19, caractérisé en ce que le disque est en molybdène.

21. Dispositif selon l'une des revendications 19 ou 20, dans la mesure où elle dépend de la revendication 17, caractérisé en ce que la connexion entre la troisième piste et le disque métallique est établie au moyen d'au moins une broche métallique traversant la monture dans le centre d'une perle isolant et traversant la couronne réfractaire, cette broche présentant une longueur appropriée à assurer le contact avec le disque métallique.

22. Dispositif selon l'une des revendications 16 à 21, caractérisé en ce que les pistes conductrices sont des couronnes concentriques.

23. Dispositif selon la revendication 22, caractérisé en ce que les pistes sont rigides et isolées électriquement au moyen de couronnes de matériau isolant réfractaire.

24. Dispositif selon l'une des revendications 16 à 23, caractérisé en ce que la face supérieure du support de monture comprend des plots d'alimentation électrique, en nombre au moins égal au nombre de pistes de la monture, disposés selon un dessin approprié à venir en contact chacun avec une des pistes de la monture.

25. Dispositif selon la revendication 24, caractérisé en ce que la face inférieure de la monture comprend un axe de centrage de dimension appropriée à s'emboîter dans une ouverture du support de monture.

26. Dispositif selon l'une des revendications 24 ou 25, caractérisé en ce que le support de monture est un plateau tournant autour d'un axe solidaire du dispositif.

27. Dispositif selon la revendication 26, caractérisé en ce que l'alimentation des plots du plateau tournant se fait par le frottement de pistes électriques tournantes solidaires du plateau tournant, et de pistes électriques fixes solidaires du dispositif, ces pistes étant isolées les unes des autres et de leur support respectif, et les pistes du plateau tournant étant reliées électriquement respectivement aux plots du plateau tournant, ces pistes étant en outre en nombre au moins égal à celui des pistes de la monture.

28. Dispositif selon l'une des revendications 12 à 27, caractérisé en ce que les éléments isolants réfractaires en dehors du disque portant les résistances chauffantes sont en céramique.

29. Dispositif selon la revendication 28, caractérisé en ce que la céramique est l'alumine.

30. Dispositif selon la revendication 29, caractérisé en ce que l'axe de la monture est muni d'un décrochement pour pouvoir être saisi par une fourche.

31. Dispositif selon la revendication 30, caractérisé en ce que le support de monture est muni d'une lumière raccordée à l'ouverture de centrage pour introduire l'axe de la monture au moyen d'une fourche, avant de le centrer dans l'ouverture de centrage.

FIG.1

1-Ⅵ-PHF 88-648

**FIG.2a**

FIG.2b

EP 0 376 387 A1

3-Ⅵ-PHF 88-648

FIG.2c

FIG.3

EP 0 376 387 A1

5-VI-PHF 88-648

FIG.4a

FIG 4b

6-VI-PHF 88-648

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-4491173 (DEMAND)<br>* colonne 3, ligne 9 - colonne 5, ligne 2; revendications 1, 10, 17; figure 1 * | 1 | H01L21/00 |
| A | | 2, 3,<br>10-12,<br>16, 18,<br>24 | |
| | --- | | |
| A | PATENT ABSTRACTS OF JAPAN<br>vol. 8, no. 247 (E-278)(1684) 13 novembre 1984,<br>& JP-A-59 124140 (FUJITSU K.K.) 18 juillet 1984,<br>* le document en entier * | 1, 8,<br>28, 29 | |
| | ----- | | |

**DOMAINES TECHNIQUES RECHERCHES (Int. Cl.5)**

H01L
G03F

Le présent rapport a été établi pour toutes les revendications

| Lieu de la recherche | Date d'achèvement de la recherche | Examinateur |
|---|---|---|
| LA HAYE | 04 AVRIL 1990 | RIEUTORT A.S. |